# EUROPÄISCHE PATENTSCHRIFT

(11) **EP 2 396 666 B1**
(45) Veröffentlichungstag und Bekanntmachung des Hinweises auf die Patenterteilung: **25.09.2013**
(21) Anmeldenummer: 10729780.6
(22) Anmeldetag: 10.02.2010
(51) Int. Cl.: G01R 33/07, G01R 33/09, G01D 5/14

(54) **ANORDNUNG ZUR MESSUNG MINDESTENS EINER KOMPONENTE EINES MAGNETFELDES**
ASSEMBLY FOR MEASURING AT LEAST ONE COMPONENT OF A MAGNETIC FIELD
DISPOSITIF DE MESURE D'AU MOINS UNE COMPOSANTE D'UN CHAMP MAGNÉTIQUE

(30) Priorität: 10.02.2009 DE 102009008265
(43) Veröffentlichungstag der Anmeldung: 21.12.2011
(73) Patentinhaber: Sensitec GmbH, 35633 Lahnau (DE)
(72) Erfinder: LOREIT, Uwe, 35580 Wetzlar (DE); SCHMITT, Jochen, 35216 Biedenkopf (DE)
(74) Vertreter: Schubert, Siegmar
(86) Internationale Anmeldenummer: PCT/EP2010/000824
(87) Internationale Veröffentlichungsnummer: WO 2010/091846

(56) Entgegenhaltungen:
- EP-A2- 1 182 461
- DE-A1- 19 817 356
- DE-A1- 19 956 361
- DE-C1- 19 532 674

## Beschreibung

Die Erfindung betrifft Anordnungen zur Messung einer oder mehrerer Komponenten eines Magnetfeldes. Als magnetfeldempfindliche Messelemente in Schichtform können solche, die auf eine Feldkomponente in der Schichtebene reagieren, z. B. magnetoresistive Schichtwiderstände oder vertikale Hall-Elemente, eingesetzt werden. Richtung und Stärke der einwirkenden Feldkomponenten werden durch weichmagnetische Flussführungen bestimmt. Die Anordnungen eignen sich für die Messung von Magnetfeldern geringerer Intensität, wie z.B. für die Realisierung eines elektronischen Kompass. Anordnungen der genannten Art sind bekannt. So wird in der Offenlegungsschrift US 2002/0021124 ein Sensor vorgestellt, bei dem Hall-Sensoren mit senkrecht zur Sensorschichtebene ausgebildeter Magnetfeldempfindlichkeit eingesetzt werden, um die Richtung eines Magnetfeldes, das parallel zur Sensorschichtebene verläuft, zu bestimmen. Die Hallsensoren sind unter einer kreisförmigen weichmagnetischen Flusskonzentratorfläche in Randnähe angeordnet, die sich in der Ebene erstreckt, in der die Feldrichtung bestimmt werden soll. In Randnähe der Flusskonzentratorfläche treten besonders stark senkrecht zu deren Ebene gerichtete Feldkomponenten auf, deren Richtung an gegenüberliegenden Rändern der kreisförmigen Fläche entgegengesetzt ist. Dort positionierte Hall-Sensoren liefern deswegen Ausgangsspannungen gleichen Betrages, aber entgegengesetzten Vorzeichens. Die Stärke des Magnetfeldes in Richtung der Verbindungslinie der beiden Sensoren lässt sich so aus der Differenz der beiden Signale ermitteln. Die Nutzung eines zweiten Sensorpaares mit einer Verbindungslinie, die mit der ersten einen Winkel von 90° bildet, gestattet so die Bestimmung des Verhältnisses der Feldkomponenten in der Ebene des Flusskonzentrators und damit die Angabe der Richtung des Feldes. Ähnliche Anordnungen mit einem anderen Verfahren der Ermittlung der Feldrichtung durch Nutzung einer Vielzahl von Hallsensorpaaren werden in der Offenlegungsschrift US 2007/0029998 vorgeschlagen. Nachteilig an den genannten Anordnungen sind einerseits die relativ geringe Feldempfindlichkeit der Hallsensoren und andererseits die begrenzte Felderhöhung durch den Flusskonzentrator. Damit ergeben sich trotz des günstigen Differenzverfahrens nicht genügend hohe Hallspannungen, um bei Auftreten der unvermeidlichen Offsetspannungen der Sensoren genügend geringe Fehler bei der Winkelbestimmung zu erreichen.

In der Offenlegungsschrift DE 199 56 361 wird die Verwendung von Vielschicht-GMR-Streifenwiderständen, die in Spalten eines kreisförmigen, in viele Sektoren aufgespaltenen Flusskonzentrators angeordnet sind, beschrieben. Die Vielschicht-GMR-Streifenwiderstände haben zwar eine höhere Feldempfindlichkeit als Hall-Sensoren, ihre Widerstandsänderung ist jedoch unabhängig davon, ob die Feldrichtung positiv oder negativ ist. Damit sind signalverdoppelnde Differenzmessungen ausgeschlossen. Die durch den sektorförmig aufgeteilten Flusskonzentrator bewirkten Feldverstärkungen in den Spalten sind vom Abstand zum Mittelpunkt und vom Winkel gegenüber dem Feld abhängig und verstärken so die Abweichungen von der Sinusförmigkeit des Signals bei Drehung des Feldes, die bei Vielschicht-GMR-Streifenwiderständen von vornherein nicht gegeben ist. Diese wird jedoch bei der Auswertung vorausgesetzt.

Eine Anordnung zur Begrenzung der Verstärkung des Feldes in einem Spalt eines Flusskonzentrators bei hohen Feldstärken wird der Offenlegungsschrift US 2006/0126229 angegeben. Die Anordnung dient jedoch lediglich der Feststellung der Feldrichtung und nicht der Messung der Stärke einer Feldkomponente.

In dem im Internet veröffentlichten "NVE Corporation Catalog: Analog Sensors, Application Notes, p. 94" wird beschrieben, wie mit Vielschicht-GMR-Streifenwiderständen trotz ihrer im Magnetfeld symmetrischen Kennlinie Brückenschaltungen hoher Magnetfeldempfindlichkeit bei geringer Temperaturabhängigkeit der Ausgangssignale realisiert werden können. Dazu werden zwei in der Brückenschaltung diagonal gegenüber liegenden GMR-Widerstandsstreifen im Spalt zwischen zwei weichmagnetischen Flächen eines Feldkonzentrators und die beiden anderen diagonalen GMR-Widerstandsstreifen unterhalb der weichmagnetischen Flächen angeordnet. Letztere sind so dem Einfluss des zu messenden Feldes entzogen. Auf die GMR-Widerstandsstreifen im Spalt wirkt das verstärkte äußere Feld. Die Feldverstärkung im Spalt ist näherungsweise durch das Verhältnis der Längsausdehnung des Flusskonzentrators in Feldrichtung zur Spaltbreite gegeben, wenn das Magnetfeld in Längsausdehnungsrichtung anliegt. Bei Abweichungen der Richtung ergeben sich mit zunehmenden Winkel größere Differenzen zu einem sinusförmigen Signalverlauf, wodurch eine Komponentenmessung ausgeschlossen wird.

Wegen ihrer hohen Feldempfindlichkeit sind Spin-Valve-GMR-Sensoren gut geeignet (A. Bartos, "GMR-Sensoren für die Messung kleiner magnetischer Feldstärken", 9.Symposium Magnetoresistive Sensoren und Magnetische Systeme, 13.-14.03.2007,Wetzlar, S.112). Sollen mit diesen Sensoren jedoch Brückenschaltungen für verschiedene Komponenten des Magnetfeldes hergestellt werden, ist es erforderlich, die Magnetisierung der gepinnten Schichten der Spin-Valve-Schichtsysteme für jede Brücke in zwei unterschiedlichen Richtungen einzustellen. Da bis zu drei Komponenten gemessen werden müssen, ergeben sich sechs Einstellrichtungen. Dazu ist ein erheblicher Aufwand zu betreiben, wie beispielsweise der Offenlegungsschrift DE 198 30 344 zu entnehmen ist. Es kommt noch erschwerend hinzu, dass die Spin-Valve-Schichtsysteme, deren Antiferromagnet leichter drehbar ist, was den Einstellvorgang der Richtung der gepinnten Schicht vereinfacht, gegenüber thermischen und magnetischen Belastungen oder Störungen, wie sie bei Montage- und Lötarbeiten auftreten, relativ instabil sind. Für stabile Antiferromagneten sind wirtschaftliche Ausrichtungsverfahren nicht bekannt.

Aus dem Dokument DE 195 32 674 C2 ist ein Drehwinkelgeber unter Verwendung von GMR-Streifenleitern aus einem isotropen GMR-Material, also ohne definierte Empfindlichkeitsrichtung, bekannt, die in Spalte eines Substrats eingebettet sind Auf dem Substrat ist eine kreisscheibenförmige Schicht aus ferromagnetischen Material aufgebracht, die durch die Spalte in Kreissegmente aufgeteilt ist. Die in den Spalten angeordneten GMR-Streifenleiter können miteinander einen Winkel zwischen 30° und 150° einschließen. Die GMR-Streifenleiter können zu einer Brücke bzw. Halbbrücke verschaltet sein, die nur einen Eindeutigkeitsbereich der Drehwinkelerfassung von 90° hat, wenn die Schicht aus weichmagnetischem Material in vier Viertelkreissegmente oder in ein Viertelkreissegment und ein Dreiviertelkreissegment unterteilt ist. Nur mit einer um einen Winkel von z. B. 135° oder 120° und 240°verdrehten GMR-Streifenleiteranordnung, die zu zwei Brücken bzw. Halbbrücken verschaltet ist, kann ein Eindeutigkeitsbereich von 180° erreicht werden.

Weiterhin ist aus dem Dokument DE 198 17 356 A1 ein Winkelgeber zur Bestimmung eines Winkels zwischen einer Sensor-Anordnung mit Hall-Elementen und einem Magnetfeld eines Magneten bekannt, wobei innerhalb der Sensor-Anordnung, und zwar zwischen den Hall-Elementen und mit diesen drehfest verbunden, Flussleitstücke aus ferromagnetischem Material angeordnet sind. Wenigstens vier solcher Hall-Elemente sind in jeweils einem geraden radialen Spalt vorgesehen, der zwischen je zwei benachbarten viertelkreisförmigen Flussleitstücken gebildet ist. Die Empfindlichkeitsrichtungen der Hall-Elemente liegen nicht in deren Chipebene, sondern senkrecht zu dieser. Hall-Signalspannungen der mindestens vier Hall-Elemente können so ausgewertet werden, dass der Winkel zu einem vorgegebenen Null-Winkel bis zu 360° eindeutig bestimmt werden kann. Der Aufwand für die mindestens vier Hall-Elemente, die möglichst Offsetfrei und temperaturstabil sein sollen, und für die Mittel zur Auswertung der Hall-Signalspannungen ist jedoch hoch.

Die Aufgabe der Erfindung besteht darin, eine Anordnung zur Messung von mindestens einer Komponente eines Magnetfeldes anzugeben, deren Einsatz auch in einem Kompass erfolgen kann und die ein einfaches Herstellungsverfahren und einen stabilen Betrieb auch nach thermischen und magnetischen Störungen ermöglicht.

Diese Aufgabe wird mit einer Anordnung gemäß dem Hauptanspruch 1 gelöst. Vorteilhafte Ausführungen sind in den Unteransprüchen 2 - 9 angegeben.

Die Messung von mehreren Magnetfeldkomponenten ist in Anspruch 10 beschrieben, wobei weitere vorteilhafte Ausgestaltungen in den nachfolgenden Ansprüchen beschrieben werden.

Für die Anordnungen zur Messung einer Magnetfeldkomponente wird ein Flusskonzentrator eingesetzt, der aus einem weichmagnetischen Flächenbereich besteht, der durch einen Spalt in 2 Teilbereiche aufgetrennt ist. Dieser Spalt verläuft nicht in gerader Linie, sondern ist aus mehreren Spaltabschnitten unterschiedlicher Längsrichtung zusammengesetzt. Es gibt mindestens einen Spaltabschnitt, dessen Längsrichtung mit der Verbindungslinie der beiden Schnittpunkte der Außenumrandung mit der Mittellinie des Spaltes einen Winkel bildet, dessen Wert entweder annähernd 45° oder 90° beträgt.

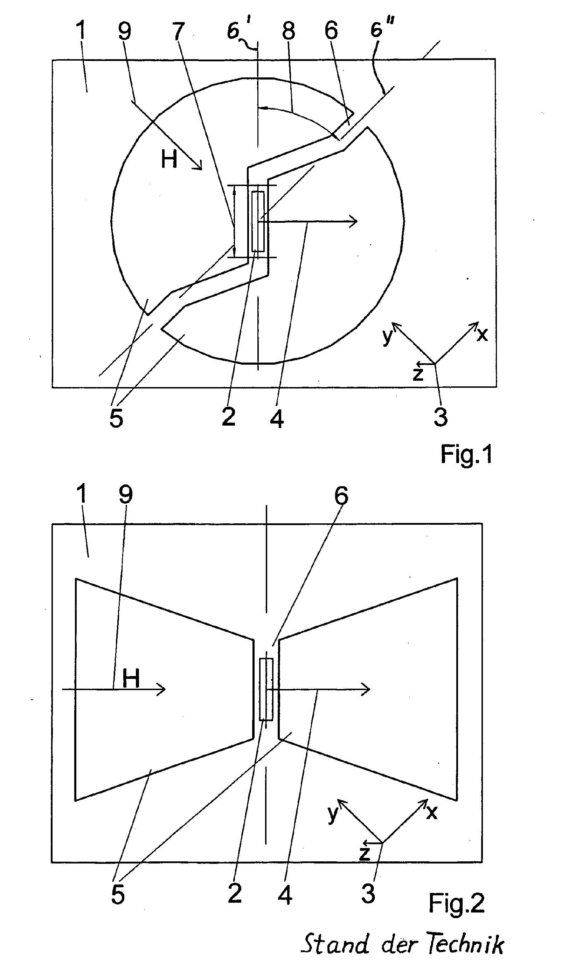

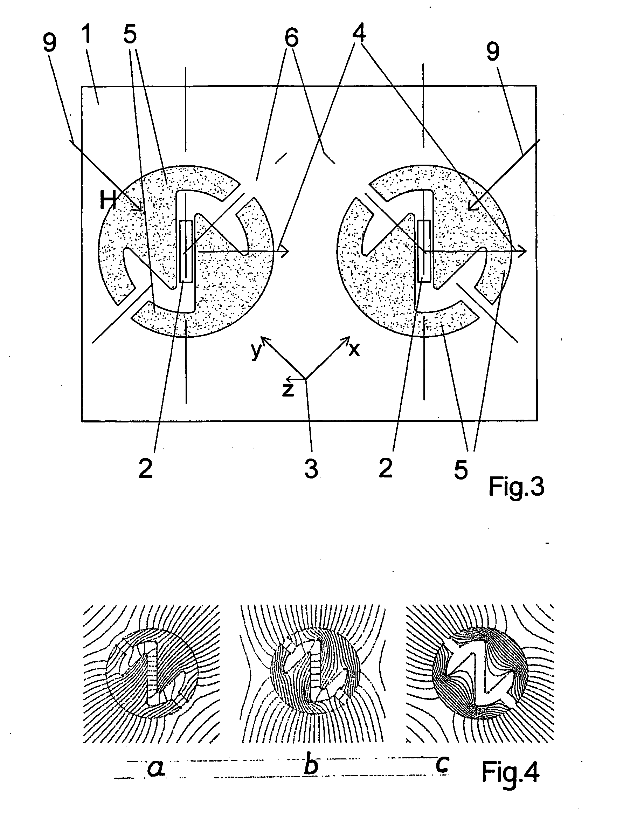

In diesem Spaltabschnitt ist mindestens ein magnetfeldempfindliches Element vorteilhaft in Streifenform (Maß in Längsrichtung deutlich größer als in Querrichtung) untergebracht. Da dieses magnetfeldempfindliche Element durch geeignete, bekannte Auswerteschaltungen ein Abbild des zu messenden Feldes erzeugt, wird im Folgenden für den Begriff "magnetfeldempfindliches Element" auch der Begriff "messwertbildendes Element" verwendet. Üblicherweise werden die weichmagnetischen Flächenbereiche sowie die magnetfeldempfindlichen Elemente in Dünnschichtverfahren auf ein Trägermaterial (Silizium, Keramik o.ä.) aufgebracht, wobei diese Einheit im Folgenden als Sensor-Chip bezeichnet wird. Das vorgenannte magnetfeldempfindliche Element weist eine Empfindlichkeitsrichtung in einer Ebene parallel zur Chipfläche auf. Vorteilhaft ist die Richtung der maximalen Empfindlichkeitsrichtung weiterhin senkrecht zu dem aufnehmenden Spaltabschnitt gewählt. Ein externes, zu messendes Magnetfeld wird innerhalb des weichmagnetischen Flächenbereiches entsprechend der magnetischen Leitfähigkeit der weichmagnetischen Teilbereiche und des Spaltes geführt und wirkt so, je nach Richtung der Feldlinien des Magnetfeldes bezogen auf die Richtung der Verbindungslinie der beiden Schnittpunkte des Spaltes mit der Außenumrandung des weichmagnetischen Flächenbereiches auf das magnetfeldempfindliche Element im Spalt ein. Stimmt die Richtung der Feldlinien des externen Magnetfeldes mit der Richtung der Verbindungslinie der beiden Schnittpunkte des Spaltes mit der Außenumrandung des weichmagnetischen Flächenbereiches überein, so wird das Magnetfeld im Inneren des Flusskonzentrators ausschließlich in den beiden weichmagnetischen Teilbereichen geführt, ein Übergang von einem weichmagnetischen Teilbereich in den anderen weichmagnetischen Teilbereich über den trennenden Spalt hinweg wird nicht auftreten. Bilden die Richtung der Feldlinien des externen Magnetfeldes mit der mit der Richtung der Verbindungslinie der beiden Schnittpunkte des Spaltes mit der Außenumrandung des weichmagnetischen Flächenbereiches einen Winkel von 90°, so muss das gesamte Magnetfeld im Inneren des Flusskonzentrators über den trennenden Spalt übertreten und kann so von dem magnetfeldempfindlichen Material im Spalt erfasst werden. Für diese Richtung des externen Magnetfeldes wird die Beeinflussung des magnetfeldempfindlichen Materials am größten, d.h. die Anordnung weist für diese Feldrichtung die größte Empfindlichkeit auf. Eine Berechnung des Verlaufes eines extern angelegten Magnetfeldes in einer beispielhaft gewählten erfindungsgemäßen Geometrie eines Flusskonzentrators ist in Fig. 4 für verschiedene Feldrichtungen dargestellt. Da der Spaltabschnitt, in dem das magnetfeldempfindliche Material angeordnet ist, mit der Verbindungslinie der beiden Schnittpunkte des Spaltes mit der Außenumrandung des weichmagnetischen Flächenbereiches einen Winkel von 45° oder 90° bildet und die Richtung der maximalen Empfindlichkeit des magnetfeldempfindlichen Materials senkrecht zur Richtung des Spaltabschnittes steht, bedeutet dies, dass das magnetfeldempfindliche Element dann am stärksten beeinflusst wird, wenn die Richtung des externen Magnetfeldes und die Richtung der maximalen Empfindlichkeit des magnetfeldempfindlichen Materials entgegen dem Stand der Technik gerade nicht übereinstimmen, sondern Winkel von 45° bzw. 90° bilden. Zur beispielhaften Erläuterung dieser Bedingungen wird auf die Fig. 1, 2 und 9 verwiesen.

Der Spalt zwischen den beiden weichmagnetischen Flächenbereichen kann vorteilhaft so gestaltet sein, dass im Spaltbereich, d.h. Spaltabschnitt, in dem das magnetfeldempfindliche Element angeordnet ist, die Spaltbreite erheblich geringer ist als in anderen Spaltabschnitten. Damit stellt der magnetische Flussanteil, der in diesem Spaltabschnitt von dem einen zu dem anderen weichmagnetischen Flächenbereich übertritt, den Hauptanteil des am gesamten Spalt übertretenden magnetischen Flusses dar. Dadurch ist die magnetische Feldstärke in diesem Feldabschnitt gegenüber der des außen angelegten Feldes stark erhöht, und die Richtung des Feldes bildet mit der Längsrichtung des Spaltabschnittes einen Winkel, der nur unerheblich von 90° abweicht. Um eine möglichst sinusförmige Abhängigkeit der durch die Anordnung erzeugten Messwerte von der Richtung des externen Magnetfeldes zu erhalten, wird die Spaltbreite in der Nähe der Außenumrandung des weichmagnetischen Flächenbereiches in einer vorteilhaften Anordnung sehr gering bemessen, wobei diese geringe Spaltbreite aber nur für einen geringen Längenanteil des Spaltes gewählt wird, damit der hier übertretende Streufluss minimiert wird.

Als Außenumrandung des weichmagnetischen Flächenbereiches ist ein Kreis oder eine Linie, die nur wenig von der Kreisform abweicht, vorteilhaft, um die Abweichungen vom sinusförmigen Verlauf der Feldstärke im geraden Spaltabschnitt mit den magnetfeldempfindlichen Elementen bei Drehung der Anordnung gegenüber dem zu messenden Magnetfeld zu minimieren. Generell ist bei der Gestaltung der erfindungsgemäßen Anordnung ein möglichst symmetrischer Aufbau des Flächenbereiches mit den eingebrachten Spaltabschnitten vorteilhaft, um bei Verdrehung der Anordnung in einem zu messenden Magnetfeld einen möglichst optimalen sinusförmigen Verlauf der Feldstärke im geraden Spaltabschnitt zu erhalten. Bei kreisförmiger Gestaltung des Flächenbereiches ist eine Punktsymmetrie auch des Spaltes bezogen auf den Kreismittelpunkt besonders vorteilhaft.

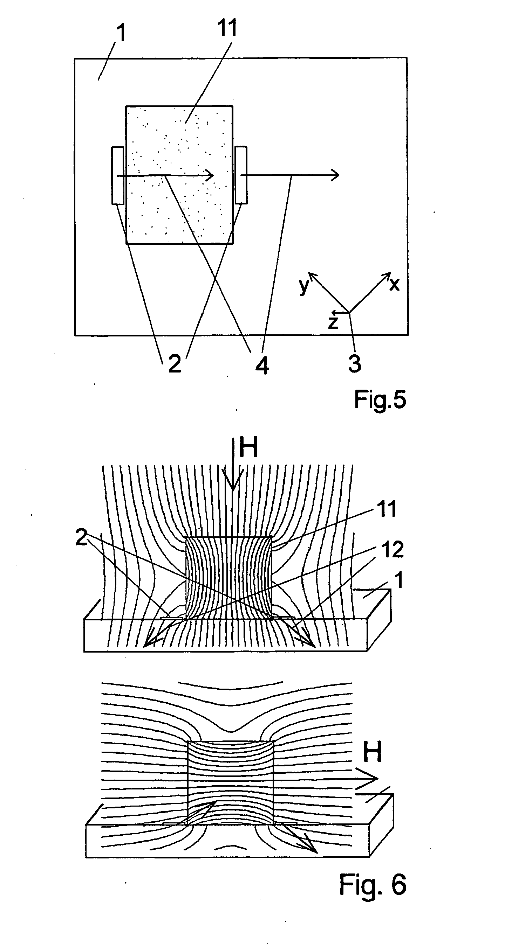

Um die zwei in einer Ebene liegenden, senkrecht aufeinander stehenden Komponenten eines zu messenden Magnetfeldes zu erfassen, ist es weiterhin vorteilhaft, zwei Flächenbereiche mit den vorgenannten Merkmalen auf dem Chip vorzusehen, wobei die beiden Flächenbereiche um 90° zueinander verdrehte maximale Empfindlichkeitsrichtungen aufweisen. Eine mögliche Ausführungsform dazu ist in Figur 3 dargestellt, wobei hier als weiterer Vorteil realisiert wurde, dass die Empfindlichkeitsrichtungen der eingebrachten magnetfeldempfindlichen Elemente in beiden Flächenbereiche identisch sind. Zur Messung aller drei orthogonal zueinander stehenden Komponenten des externen Magnetfeldes werden in einer Weiterbildung der voranstehenden Anordnung mindestens zwei weitere magnetfeldempfindliche Elemente mit gleicher Empfindlichkeitsrichtung gegenüberliegend neben einem weichmagnetischen Flächenbereich vorgesehen. Diese beiden weiteren magnetfeldfeldempfindlichen Elemente werden zur Erfassung der zur Chipebene senkrecht stehenden Komponente des Magnetfeldes genutzt. Senkrecht zur Chipebene stehende Komponenten des Magnetfeldes werden durch das weichmagnetische Material zumindest teilweise in der Ebene des magnetfeldempfindlichen Material geführt, wobei die Projektionen der lokalen Flussvektoren in die Chipebene am Ort der magnetfeldempfindlichen Elemente unterschiedliche Vorzeichen, aber idealerweise identische Amplituden aufweisen. Für Komponenten eines externen Magnetfeldes parallel zur Chipebene ergibt sich durch das weichmagnetische Material des Flusskonzentrators die Situation, dass Projektionen der lokalen Flussvektoren in die Sensorebene gleiche Vorzeichen, und nahezu identische Amplituden ausweisen. Durch Differenzbildung der durch die magnetfeldempfindlichen Elemente erzeugten Messsignale werden also die in der Chipebene liegenden Komponenten unterdrückt, während die senkrecht dazu stehenden Komponenten verstärkt abgebildet werden. Zur beispielhaften Erläuterung wird auf die nachfolgend beschriebenen Figuren 5 und 6 verwiesen. In den geraden Spaltabschnitten werden in allen Anordnungen magnetfeldempfindliche Elemente angeordnet, deren Empfindlichkeitsrichtung rechte Winkel mit deren Längsrichtung bilden und in der Chipebene liegt. Bevorzugt werden dazu magnetoresistive Widerstände benutzt, die aus Dünnschichtstreifen bestehen. Es können auch mehrere Schichtstreifen oder Widerstände in einem Spaltabschnitt untergebracht sein. Werden Widerstände, deren Widerstandsänderung durch den anisotropen magnetoresistiven (AMR) Effekt bedingt ist, eingesetzt, sollten diese zur Linearisierung der Kennlinie in bekannter Weise mit einer Barberpol-Struktur von hochleitfähigen Schichten versehen sein. Bei Verwendung einer Barberpol-Struktur mit gleichem Neigungswinkel für alle AMR-Schichtstreifen können Halbbrückenschaltungen aus je einem im Spalt angeordneten Widerstand und einem oberhalb oder unterhalb der weichmagnetischen Flächenbereiche angeordneten realisiert werden. Bei Verwendung von Barberpol-Strukturen mit entgegengesetzt gleichem Neigungswinkel ist die Änderung des Widerstandes im Magnetfeld gegenläufig und Halbbrücken können aus zwei in einem Spalt angeordneten Widerständen bestehen.

Werden zwei oder mehr gerade parallele Spaltabschnitte angeordnet, kann das in jeweils zwei nebeneinanderliegenden Spaltabschnitten auftretende Magnetfeld genutzt werden, um die gegenläufige Änderung der Widerstände der Halbbrücken bei gleichem Neigungswinkel der Barberpol-Struktur zu bewirken. Brücken mit Barberpol-Strukturen gleicher Neigung weisen vorteilhafterweise geringere Offset-Spannungswerte auf. Da die erfindungsgemäßen Messanordnungen für zwei oder drei Feldkomponenten so gestaltet sind, dass alle magnetoresistiven Schichtstreifen parallel liegen und dieselbe Empfindlichkeitsrichtung aufweisen können, tritt dieser Vorteil auch in allen Mehrkomponentenanordnungen auf.

Als magnetfeldempfindliche Elemente sind ebenfalls Schichtwiderstände einsetzbar, deren Widerstandsänderung durch den "Gigantischen Magnetoresistiven" (GMR) Effekt bewirkt wird. Vorzugsweise werden Spin-Valve-Schichtsysteme verwendet, die eine gepinnte Schicht mit fest einstellbarer Magnetisierungsrichtung und eine freie Schicht mit durch ein angelegtes Magnetfeld einzustellender Magnetisierungsrichtung enthalten. Der Widerstandswert der Schicht variiert mit dem Winkel zwischen beiden Magnetisierungsrichtungen. Um einen linearen Kennlinienbereich in der Umgebung des Magnetfeldes Null zu erreichen, sind Schichtstreifen parallel zur Längsrichtung der geraden Spaltabschnitte anzuordnen, und die Magnetisierungsrichtung der gepinnten Schicht ist quer dazu einzustellen. Wie bereits für den Fall des Einsatzes von AMR-Sensoren dargestellt, sind die erfindungsgemäßen weichmagnetischen Schichtbereiche so geformt, dass Halb- und Vollbrückenanordnungen mit Streifenwiderständen einer einzigen Empfindlichkeitsrichtung realisierbar sind. Das gilt vorteilshafterweise sowohl für Anordnungen zur Einkomponenten-, Zweikomponenten- und Dreikomponentenmessung von Magnetfeldern. Für Spin-Valve-Sensoren ist das von besonderer Bedeutung, da hier die Einstellung der entgegengesetzt gerichteten Empfindlichkeit die Ummagnetisierung der gepinnten Schicht erfordern würde. Diese Einstellung ist aufwendig und kompliziert, besonders im Falle von gepinnten Schichten, die stabil gegen magnetische und thermische Störungen beim Aufbau und im Einsatz der Messanordnungen sind. Bei den erfindungsgemäßen Anordnungen kann die Einstellung der Magnetisierung der gepinnten Schicht einfach beim Herstellungsprozess erfolgen. Sollte doch eine Änderung dieser Einstellung auftreten, kann der Ausgangszustand durch einen einfachen Tempervorgang des gesamten Sensorchips im Magnetfeld wiederhergestellt werden, ohne dass lokale Aufheizungen oder lokal unterschiedliche Magnetfelder einzusetzen sind.

Die Flächenbereiche weichmagnetischen Materials bestehen bevorzugt aus einer galvanisch abgeschiedenen Eisen-Nickel-Legierung Solche Schichten können mit Dicken von etwa 30 Mikrometern hergestellt werden. Damit ist die Schichtdicke des weichmagnetischen Materials sehr viel größer als die Dicke der Schichtstreifen der magnetoresistiven Widerstände, was insbesondere für die Messung der zur Chipebene senkrecht stehenden Magnetfeldkomponente von Vorteil ist.

Die Anordnung von feldempfindlichen Elementen in benachbarten parallelen geraden Spaltabschnitten ermöglicht das Eliminieren von Messfehlern, die sich infolge der leicht von der Querrichtung abweichenden Feldrichtung in den Spaltabschnitten in den einzelnen Widerständen einstellen.

Die Symmetrie der Anordnungen erleichtert die Herstellung von Messanordnungen für unterschiedliche Komponenten mit gleichen Eigenschaften.

Weitere Vorteile, Merkmale und Einzelheiten der Erfindung ergeben sich aus den im Folgenden beschriebenen Ausführungsbeispielen sowie anhand der Zeichnungen. Beigefügt sind folgende Zeichnungen:
- Fig. 1:: Erfindungsgemäßes Prinzip zur Messung von einer in der Chipebene liegenden Komponente eines Magnetfeldes.
- Fig. 2:: Stand der Technik zur Erfassung von einer in der Chipebene liegenden Komponente eines Magnetfeldes unter Einsatz von Flussführungen bzw. -konzentratoren.
- Fig. 3:: Erfindungsgemäße Anordnung zur Messung von zwei orthogonalen in der Chipebene liegenden Komponenten eines Magnetfeldes.
- Fig. 4:: Feldlinienverläufe in einem erfindungsgemäßen weichmagnetischen Flächenbereich bei Magnetfeldern unterschiedlicher Richtung.
- Fig. 5:: Anordnung zur Messung der senkrecht zur Chipebene liegenden Komponente des Magnetfeldes.
- Fig. 6.: Verlauf der Magnetfeldlinien an einer dicken weichmagnetischen Schicht mit benachbarten magnetfeldempfindlichen Schichtstreifen bei zur Chipebene senkrechtem und parallelem Feld.
- Fig. 7:: Komplette Anordnung zur Messung von zwei in der Chipebene liegenden Komponenten eines Magnetfeldes, jeweils mit magnetoresistiver Vollbrücke.
- Fig. 8:: Prinzip zur Messung von einer Feldkomponente in der Chipebene und einer dazu senkrechten Feldkomponente.
- Fig. 9:: Weitere Anordnung zur Messung einer Feldkomponente mittels Vollbrücke
- Fig. 10:: Komplette Anordnung zur Messung von zwei in der Chipebene liegenden Komponenten eines Magnetfeldes, jeweils mit magnetoresistiver Vollbrücke und magnetoresistiven Widerständen in drei parallelen geraden Spaltabschnitten.

Fig. 1 zeigt in einer Skizze eine beispielhafte Anordnung zur Messung einer Magnetfeldkomponente in der Ebene eines Sensorchips 1 mit Hilfe eines magnetfeldempfindlichen Elementes 2. Die Ebene des Sensorchips 1 ist die x- y- Ebene. Die z- Richtung steht senkrecht auf der Ebene des Sensorchips 1 und zeigt hier nach oben. Eine zunächst kreisförmige Fläche aus weichmagnetischem Material wird durch einen Spalt 6 in zwei Teilbereiche 5 getrennt. Der Spalt 6 ist aus mehreren Spaltabschnitten zusammengesetzt, die voneinander abweichende Richtungen aufweisen. In einem Spaltabschnitt ist das magnetfeldempfindliche Messelement angeordnet, dessen Empfindlichkeitsrichtung 4 senkrecht zur Ausdehnungsrichtung des aufnehmenden Spaltes ist. Die Ausdehnungsrichtung 6' dieses aufnehmenden Spaltabschnittes und die Verbindungslinie 6" der beiden Schnittpunkte des Spaltes mit der Außenumrandung des weichmagnetischen Flächenbereiches bilden einen Winkel 8 von 45°. Das externe, zu messende Magnetfeld 9 wird im weichmagnetischen Material geführt und tritt von einem Teilbereich 5 über den Spalt 6 in den gegenüberstehenden zweiten Teilbereich 5 über und kann im Spalt 6 mittels des magnetfeldempfindlichen Schichtstreifens 2 detektiert werden. Diese Anordnung weist gerade in der gezeigten Richtung 9 die maximale Empfindlichkeit auf, wobei die Empfindlichkeitsrichtung 4 des magnetfeldempfindlichen Schichtstreifens zu dieser Richtung 9 einen Winkel von 45° aufweist. Für die Erläuterung der maximalen Empfindlichkeiten bei erfindungsgemäß vergleichbaren Anordnungen sei hier auf die Fig. 4 verwiesen. Die Außenumrandung der Anordnung in Fig. 1 ist nahezu kreisförmig. Vorteilhaft ist hier auch die Punktsymmetrie der Anordnung um den Mittelpunkt des ursprünglichen Kreises. Bei Verdrehung der Anordnung um 360° wird somit ein sinusförmiger Verlauf des vom magnetfeldempfindlichen Schichtstreifen 2 gebildeten Messwertes erreicht.

In Fig. 2 ist eine beispielhafte Anordnung einer Flussführung und Verstärkung zur Messung eines Magnetfeldes gemäß dem Stand der Technik dargestellt. Im Spalt 6 zwischen 2 weichmagnetischen Flächen 5 ist ein magnetfeldempfindliches Element 2 angeordnet. Der Spalt 6 ist hier nicht aus mehreren Spaltabschnitten unterschiedlicher Richtung zusammengesetzt, sondern durchgängig gerade. Die Empfindlichkeitsrichtung 4 des magnetfeldempfindlichen Elementes 2 ist auch hier senkrecht zur Längsausdehnung des magnetfeldempfindlichen Elementes 2. Bedingt durch die realisierte Gesamtstruktur der Anordnung sind jedoch die maximale Empfindlichkeitsrichtung der Anordnung gemäß Richtung 9 und der Empfindlichkeitsrichtung 4 des magnetfeldempfindlichen Elementes identisch. Bei Verdrehung der Anordnung um 360° lässt sich erkennen, dass minimale und maximale Empfindlichkeit der Anordnung auch hier um jeweils 90° versetzt sind, allerdings zeigen die vom Element 2 gebildeten Messwerte aufgrund der geometrischen Form der weichmagnetischen Teilbereiche 5 hier keinen sinusförmigen Verlauf.

In Fig. 3 Ist eine beispielhafte Anordnung zur Erfassung der beiden orthogonalen, in der Chipebene liegenden Richtungen eines Magnetfeldes gezeigt. Jedes der beiden gezeigten Elemente mit nahezu kreisförmiger Außenumrandung weist die genannten Merkmale auf, dass ein Flächenbereich aus weichmagnetischem Material durch einen Spalt in jeweils 2 Teilbereiche 5 aufgetrennt wird. Der Spalt ist jeweils aus mehreren Spaltabschnitten zusammengesetzt, die unterschiedliche Längsrichtungen aufweisen. Die Richtung der maximalen Empfindlichkeit 4 für die eingebrachten magnetfeldempfindlichen Elemente 2 ist für beide Elemente gleich, was fertigungstechnisch deutliche Vorteile bietet. Die Verbindungslinie der beiden Schnittpunkte der Außenumrandung mit der Mittellinie des Spaltes 6 bildet in beiden Elementen Winkel von jeweils 45° mit der Längsrichtung des das magnetfeldempfindliche Element 2 aufnehmenden Spaltabschnittes.

Allerdings ist der Spalt des rechten Elementes spiegelsymmetrisch zum Spalt im linken Element eingebracht, sodass die Verbindungslinie der beiden Schnittpunkte der Außenumrandung mit der Mittellinie des Spaltes des linken Elementes und die Verbindungslinie der beiden Schnittpunkte der Außenumrandung mit der Mittellinie des Spaltes des rechten Elementes rechtwinklig aufeinander stehen. Praktisch bedeutet dies, dass die beiden Elemente senkrecht zueinander stehende maximale Empfindlichkeitsrichtungen 9 aufweisen. Das linke Element ist somit für die Erfassung der Y-Komponente und das rechte Element für die Erfassung der x-Komponente eines auf die Anordnung wirkenden Magnetfeldes geeignet. Vorteilhaft weisen die Spaltbereiche in jedem Element unterschiedliche Spaltbreiten auf, was insbesondere mögliche Fehlereinflüsse aufgrund von unerwünschtem übertretenden Magnetfluss abseits der magnetfeldempfindlichen Elemente 2 minimiert.

In Fig. 4 sind für die Basisstruktur aus Figur 3 drei verschiedene Konstellationen bzgl. der Flussführung im Sensor-Element in Abhängigkeit von der Richtung des externen Magnetfeldes dargestellt. In Fig. 4a stehen Richtung des Magnetfeldes und die Verbindungslinien der Spaltöffnungen senkrecht zueinander. In diesem Fall müssen alle Feldlinien im Sensor-Element von einem weichmagnetischen Teilbereich über den Spalt in den zweiten weichmagnetischen Teilbereich übertreten. Im Bereich des inneren Spaltabschnittes, in dem beispielhaft die magnetfeldempfindlichen Elemente untergebracht sind stehen die Feldlinien senkrecht zu Richtung des Spaltbereiches. Für diese Konstellation ist die Empfindlichkeit des Sensorelementes maximal. Stehen Magnetfeld und die Verbindungslinien der Spaltöffnungen im Winkel von 45° zueinander (Fig. 4b), so wird ein Teil des Magnetflusses ausschließlich in dem weichmagnetischen Bereich geführt und ein Teil wird vorrangig im Bereich des inneren Spaltabschnittes über den Spalt zwischen den beiden weichmagnetischen Flächenbereichen geführt. Haben externes Magnetfeld und die Verbindungslinien der Spaltöffnungen gemäß Fig. 4c die gleiche Richtung, so wird das Magnetfeld ausschließlich in den weichmagnetischen Bereichen geführt. Ein Übergang über den Spaltbereich hinweg tritt nicht auf, evtl. in den Spalt eingebrachte magnetfeldempfindliche Elemente werden keine Beeinflussung erfahren. Somit ist das Sensorelement unempfindlich für Magnetfeld-Komponenten in dieser dargestellten Richtung.

Für die Messung der z-Komponente eines externen Magnetfeldes ist eine beispielhafte Anordnung in Fig. 5 dargestellt. In der Chipebene ist eine Fläche weichmagnetisches Material 11 aufgebracht, an dessen Rand zwei magnetfeldempfindliche Elemente 2 parallel ebenfalls in der X-Y-Ebene (Chipebene) mit identischen Empfindlichkeitsrichtungen 4 angeordnet sind. Die nachfolgende Fig. 6 zeigt die Beeinflussung der beiden magnetfeldempfindlichen Elemente bei vorhandenem externem Magnetfeld H. In Fig. 6a wirkt das Magnetfeld in z-Richtung auf die Anordnung ein. Bedingt durch die Flussführung im weichmagnetischen Material entstehen in diesem Fall am Ort der beiden magnetfeldempfindlichen Elemente 2 Flussvektoren 12, die symmetrisch zu einer Ebene senkrecht zur Chipebene 1 sind. Die beiden magnetfeldempfindlichen Elemente werden also genau von entgegengesetzt gerichteten Flussanteilen beeinflusst. Ist das zu messende Magnetfeld parallel zur Chipebene, so wirken am Ort der magnetfeldempfindlichen Materialstreifen zwei Flussvektoren, deren Komponenten in der Chipebene gleich gerichtet sind. Bilden die Materialstreifen externe Magnetfeldkomponenten in der Ebene hinsichtlich Amplitude und Richtung getreu ab, so wird durch Differenzbildung erreicht, dass Magnetfeldkomponenten senkrecht zur Chipebene erfasst werden, während die Magnetfeldkomponenten parallel zur Chipebene sich nach der Differenzbildung gerade aufheben.

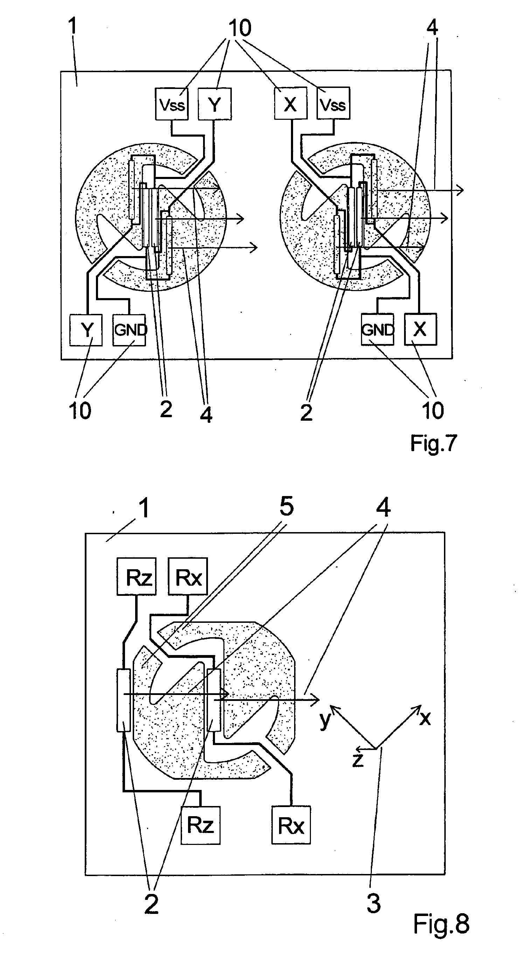

In den bisher beschriebenen Figuren 1 - 6 ist nur die Verwendung eines oder von zwei magnetoresistiven Widerständen für jede Feldkomponente vorgesehen. Wie an sich bekannt können jedoch deutlich bessere Messergebnisse mit Brückenschaltungen aus solchen Widerständen erhalten werden können. Der Fig. 7 ist zu entnehmen, wie Brückenschaltungen in die erfindungsgemäße Lösung einzubeziehen sind. Dargestellt sind die gleichen Flusskonzentratoren aus jeweils zwei weichmagnetischen Flächenbereichen wie in Fig. 3. Die Wheatstone-Brücke für die x-Komponente des Feldes ist aus vier parallelen magnetoresistiven Brückenelementen aufgebaut. Zwei der Brückenelemente 2 sind jeweils nebeneinander im geraden Spaltabschnitt angeordnet. Die beiden anderen Brückenelemente befinden sich auf dem Sensorchip 1 unterhalb der weichmagnetischen Flächenbereiche. Die Brückenelemente im Spaltabschnitt sind dem dort vorhandenen verstärkten Feld ausgesetzt, während die Brückenelemente unter der weichmagnetischen Fläche wegen ihrer unmittelbaren Nähe zu dieser vom äußeren Feld abgeschirmt sind. Sie tragen also nichts zum Brückensignal bei und werden nur zur Einstellung eines geringen Brückenoffsets und dessen geringer Temperaturabhängigkeit benötigt. Der Aufbau der Brücke für die y-Komponente des Feldes ist spiegelsymmetrisch zur beschriebenen. Alle magnetfeldempfindlichen Richtungen 4 der Brückenelemente sind gleich. Ihre Realisierung durch Spin-Valve-Schichtwiderstände ist also wieder vorteilhaft. Das Prinzip einer Anordnung zur Messung einer Feldkomponente x in der Ebene des Sensorchips 1 und der dazu senkrechten Komponente zeigt Fig. 8. Die x-Komponente wird wie oben erläutert durch das im Spalt liegende magnetfeldempfindliche Element 2 ermittelt. Zur Bestimmung der z-Komponente dient ein zusätzliches magnetfeldempfindliches Element 2, das unmittelbar am Rand des weichmagnetischen Bereiches 5 angeordnet ist und dieselbe magnetfeldempfindliche Richtung aufweist wie das Element im Innern des Spaltes.

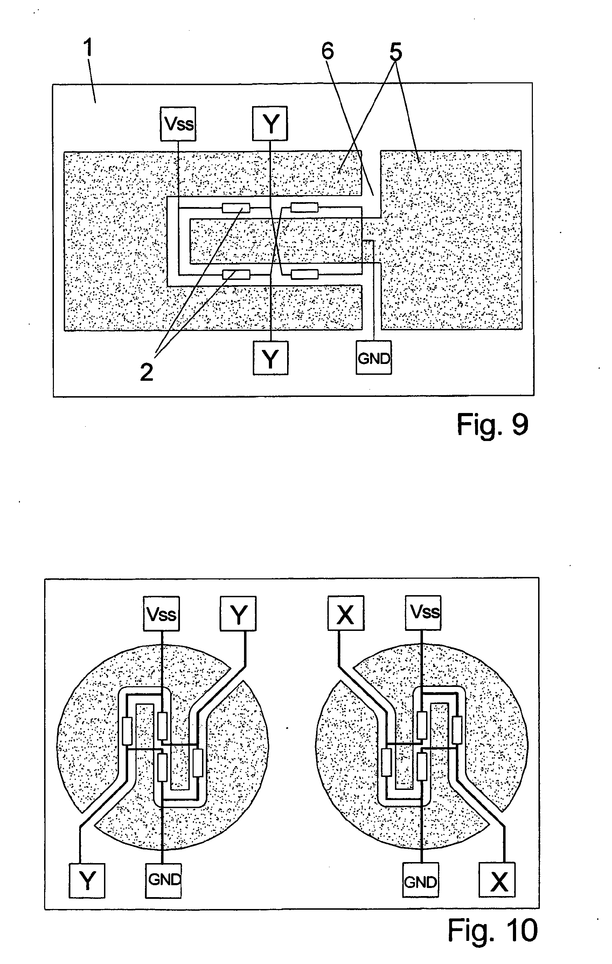

Fig. 9 zeigt eine weitere Anordnung zur Messung einer in der Chipebene liegenden Komponente eines Magnetfeldes. In den Spaltabschnitten sind wiederum nur magnetfeldempfindliche Elemente eingebracht, die eine identische Empfindlichkeitsrichtung aufweisen und zu einer Messbrücke verschaltet sind. Zu beachten ist, dass entgegen dem beispielsweise in Fig. 2 beschriebenen Stand der Technik die Empfindlichkeitsrichtung 4 der magnetfeldempfindlichen Elemente und die Empfindlichkeitsrichtung 9 der Anordnung (=Sensors) einen Winkel von 90° bilden.

Eine Verbesserung der Empfindlichkeit und der Messgenauigkeit der Anordnung kann durch eine weiter verbesserte Spaltgeometrie erreicht werden. Fig. 10 zeigt dazu beispielhaft eine Anordnung für die Bestimmung der Feldkomponenten x, y in der Ebene des Sensorchips 1. Der Spalt enthält hier drei parallele gerade Spaltabschnitte. Die Feldrichtung in den Spaltabschnitten steht auch hier wieder quer zur Längsrichtung der Spaltabschnitte, sie stimmt im ersten und dritten parallelen Spaltabschnitt überein und ist im mittleren dazu entgegengesetzt. Dadurch wird es möglich, alle vier magnetoresistive Widerstände der Brücke trotz gleicher Kennlinie und Empfindlichkeitsrichtung in dem Spalt unterzubringen und eine gegenläufige Widerstandsänderung der Widerstände jeder Halbbrücke zu erzielen. Diese Anordnung hat neben der höheren Empfindlichkeit noch den Vorteil, dass der Einfluss eines nicht genau um 90° gegen die Längsrichtung des geraden Spaltabschnittes gedrehten Magnetfeldes hier herausgemittelt wird. Es wird hier nochmals darauf hingewiesen, dass bei allen beschriebenen Ausführungsbeispielen vorteilhaft nur magnetoresistive Sensorelemente mit übereinstimmender Empfindlichkeitsrichtung benutzt werden. Damit erübrigt sich beim Einsatz von Spin-Valve-Sensoren das aufwendige Ausrichten der Magnetisierungsrichtung der gepinnten Schicht einiger Sensorelemente in entgegen gesetzte Richtungen. Außerdem werden für eine Anordnung zur Messung aller drei Feldkomponenten nur Funktionsteile eingesetzt, die alle direkt auf einer Chipebene gefertigt werden können.

### Bezugszahlenliste

- 1: Sensorchip
- 2: Magnetfeldempfindliches Element
- 3: Koordinatensystem (X-Achse und Y-Achse in Chipebene, Z-Achse senkrecht dazu)
- 4: Empfindlichkeitsrichtung des magnetfeldempfindlichen Elementes
- 5: weichmagnetische Teilbereiche
- 6: Spalt
- 6': Ausdehnungsrichtung des aufnehmenden Spaltabschnitts
- 6": Verbindungslinie der beiden Schnittpunkte des Spaltes bzw. dessen äußeren Spaltöffnungen
- 7: Länge eines magnetfeldempfindlichen Elements im Spaltbereich
- 8: Winkel zwischen der Verbindungslinie der beiden Schnittpunkte des Spaltes mit der Außenumrandung des weichmagnetischen Flächenbereiches und der Richtung des aufnehmenden Spaltbereiches
- 9: Richtungsvektor eines externen Magnetfeldes
- 10: Anschlussflächen zur Kontaktierung der Messelemente oder der Messbrücke
- 11: Querschnittansicht des weichmagnetischen Materials
- 12: resultierende Feldvektoren am Ort des magnetfeldempfindlichen Materials

## Patentansprüche

1. Anordnung zur Messung mindestens einer Komponente eines Magnetfeldes (9) mit mindestens einem auf einem Sensorchip (1) angeordneten, für Richtungen in der Chipebene magnetfeldempfindlichen Element (2) und einem Flächenbereich weichmagnetischen Materials (5), wobei
- der Flächenbereich weichmagnetischen Materials durch einen einzigen Spalt, der kein weichmagnetisches Material aufweist, in zwei Teilbereiche (5) aufgetrennt ist,
- der Spalt aus Spaltabschnitten zusammengesetzt ist, die mehrere unterschiedliche Längsrichtungen aufweisen,
- mindestens ein magnetfeldempfindliches Element (2) in den Spaltabschnitten angeordnet ist und
- die Empfindlichkeitsrichtung (4) des mindestens einen eingebrachten magnetfeldempfindlichen Elements nicht mit der Längsrichtung des ihn aufnehmenden Spaltabschnitts übereinstimmt.

2. Anordnung nach Anspruch 1, **dadurch gekennzeichnet, dass** die Verbindungslinie (6) zwischen den äußeren Spaltöffnungen und die Empfindlichkeitsrichtung des mindestens einen magnetfeldempfindlichen Elements einen Winkel (8) von annähernd 45° oder 90° einschließen.

3. Anordnung nach Anspruch 2, **dadurch gekennzeichnet, dass** alle magnetfeldempfindlichen Elemente eine identische Empfindlichkeitsrichtung (4) aufweisen.

4. Anordnung nach Anspruch 3, **dadurch gekennzeichnet, dass** die Richtung der maximalen Magnetfeldempfindlichkeit (9) der Anordnung nicht mit der Empfindlichkeitsrichtung (4) des magnetfeldempfindlichen Elementes übereinstimmt.

5. Anordnung nach Anspruch 4, **dadurch gekennzeichnet, dass** die minimale Empfindlichkeitsrichtung und die maximale Empfindlichkeitsrichtung der Anordnung um 90° zueinander verdreht sind.

6. Anordnung nach einem der Ansprüche 1 bis 5, **dadurch gekennzeichnet, dass** der Flächenbereich weichmagnetischen Materials eine Rotations- oder Achsensymmetrie aufweist.

7. Anordnung nach Anspruch 6, **dadurch gekennzeichnet, dass** der Flächenbereich annähernd kreisförmig ist.

8. Anordnung nach Anspruch 7, **dadurch gekennzeichnet, dass** die magnetfeldempfindlichen Elemente magnetoresistive Widerstände sind, die auf dem AMR-, GMR- oder TMR-Effekt basieren.

9. Anordnung nach Anspruch 8, **dadurch gekennzeichnet, dass** mehrere magnetfeldempfindliche Elemente in den Spaltabschnitten vorhanden sind, die zu einer Wheatstonschen Brücke verschaltet sind.

10. Anordnung zur Messung von zwei in der Chipebene liegenden Magnetfeldkomponenten nach einem der vorangehenden Ansprüche, **dadurch gekennzeichnet, dass** zwei Flächenbereiche weichmagnetischen Materials (5) auf der Chipebene vorhanden sind, die jeweils durch einen einzigen Spalt, der kein weichmagnetisches Material aufweist, in zwei Teilbereiche (5) aufgeteilt sind, dass die beiden Verbindungslinien (6) zwischen jeweils zwei äußeren Spaltöffnungen einen Winkel von 90° einschließen und dass magnetfeldempfindliche Elemente (2), die eine identische Empfindlichkeitsrichtung (4) aufweisen, in den Spaltabschnitten eingebracht sind.

11. Anordnung nach Anspruch 10, **dadurch gekennzeichnet, dass** jeweils die Empfindlichkeitsrichtung der magnetfeldempfindlichen Elemente und die Verbindungslinie der jeweiligen beiden Spaltöffnungen einen Winkel von annähernd 45° einschließen.

12. Anordnung nach einem der Ansprüche 1 - 11, **dadurch gekennzeichnet, dass** zusätzliche magnetfeldempfindliche Messelemente neben dem mindestens einem Flächenbereich weichmagnetischen Materials angeordnet sind, mit denen senkrecht zu dem Sensorchip (1) wirkende Komponenten eines externen Magnetfeldes erfasst werden.

## Claims

1. Assembly for measuring at least one component of a magnetic field (9) including at least one element (2) magnetic field sensitive for directions in the chip plane disposed on a sensor chip (1) and a surface area of soft magnetic material (6), wherein
the surface area of soft magnetic material is ripped open into two partial areas (5) by one single clearance not having any soft magnetic material,
the clearance is composed of clearance sections having a plurality of different longitudinal directions,
at least one magnetic field sensitive element (2) is disposed in the clearance sections, and
the sensitivity direction (4) of the at least one inserted magnetic field sensitive element is not identical with the longitudinal direction of the clearance section receiving it.

2. Assembly according to claim 1,
**characterized in that** the connecting line (6) between the outer clearance openings and the sensitivity direction of the at least one magnetic field sensitive element cover an angle (8) of approximately 45° or 90°.

3. Assembly according to claim 2,
**characterized in that** all magnetic sensitive elements have an identical sensitivity direction (4).

4. Assembly according to claim 3.
**characterized in that** the direction of the maximum magnetic field sensitivity (9) of the assembly and the sensitivity direction (4) of the magnetic field sensitive element are not identical.

5. Assembly according to claim 4,
**characterized in that** the minimum sensitivity direction and the maximum sensitivity direction of the assembly are twisted about 90° relative to each other.

6. Assembly according to one of claims 1 to 5,
**characterized in that** the surface area of soft magnetic material shows rotational or axis symmetry.

7. Assembly according to claim 7,
**characterized in that** the surface area is approximately circular.

8. Assembly according to claim 7,
**characterized in that** the magnetic field sensitive elements constitute magnetoresistive resistances based on the AMR, GMR or TMR effect.

9. Assembly according to claim 8,
**characterized in that** a plurality of magnetic field sensitive elements are disposed in the clearance section and are interconnected to constitute a Wheatston bridge.

10. Assembly for measuring two magnetic field components arranged in the chip plane according to one of the foregoing claims,
**characterized in that** two surface areas of soft magnetic material (5) are provided on the chip plane each of which is divided by one single clearance not having any soft magnetic material into two partial areas (5), that the two connecting lines (6) between two outer clearance openings each cover an angle of 90°, and that magnetic field sensitive elements (2) having identical sensitivity direction (4) are provided in the clearance sections.

11. Assembly according to claim 10,
**characterized in that** the sensitivity direction of each of the magnetic field sensitive elements and the connecting line of the respective two clearance openings cover an angle of approximately 45°.

12. Assembly according to one of claims 1 to 11,
**characterized in that** additional magnetic field sensitive measuring elements are disposed next to the at least one surface area of soft magnetic material by which components of an external magnetic field directed perpendicular to the sensor chip (1) are detected.

## Revendications

1. Dispositif destiné à mesurer au moins une composante d'un champ magnétique (9), comprenant au moins un élément (2) monté sur une puce de capteur(1), sensible au champ magnétique pour les directions contenues dans le plan de la puce, et une région de surface faite d'un matériau magnétique doux (5), dans lequel
- la région de surface faite d'un matériau magnétique doux est divisée en deux régions partielles (5) par une fente unique qui ne présente pas de matériau magnétique doux,
- la fente est composée de segments de fente qui présentent plusieurs directions longitudinales différentes,
- au moins un élément sensible au champ magnétique (2) est placé dans les segments de fente et
- la direction de sensibilité (4) de l'élément sensible au champ magnétique emboîté, au moins au nombre de un, ne coïncide pas avec la direction longitudinale du segment de fente qui le reçoit.

2. Dispositif selon la revendication 1, **caractérisé en ce que** la ligne de jonction (6) entre les ouvertures extérieures de la fente et la direction de sensibilité de l'élément sensible au champ magnétique, au moins au nombre de un, forme un angle (8) d'environ 45° ou 90°.

3. Dispositif selon la revendication 2, **caractérisé en ce que** tous les éléments sensibles au champ magnétique présentent la même direction de sensibilité (4).

4. Dispositif selon la revendication 3, **caractérisé en ce que** la direction de sensibilité maximale au champ magnétique (9) du dispositif ne coïncide pas avec la direction de sensibilité (4) de l'élément sensible au champ magnétique.

5. Dispositif selon la revendication 4, **caractérisé en ce que** la direction de sensibilité minimale et la direction de sensibilité maximale du dispositif sont décalées entre elles de 90°.

6. Dispositif selon l'une des revendications 1 à 5, **caractérisé en ce que** la région de surface faite d'un matériau magnétique doux présente une symétrie de révolution ou une symétrie axiale.

7. Dispositif selon la revendication 6, **caractérisé en ce que** la région de surface est approximativement circulaire.

8. Dispositif selon la revendication 7, **caractérisé en ce que** les éléments sensibles au champ magnétique sont des résistances magnétorésistives qui sont basées sur l'effet AMR, GMR ou TMR.

9. Dispositif selon la revendication 8, **caractérisé en ce que**, dans les segments de fente, se trouvent plusieurs éléments sensibles au champ magnétique, qui sont connectés en un pont de Wheatstone.

10. Dispositif destiné à la mesure de deux composantes de champ magnétique contenues dans le plan de la puce selon l'une des revendications précédentes, **caractérisé en ce que**, sur le plan de la puce, sont présentes deux régions de surface faites d'un matériau magnétique doux (5) qui sont divisées chacune en deux régions partielles (5) par une unique fente qui ne présente pas de matériau magnétique doux, **en ce que** les deux lignes de jonction (6) tracées chacune entre deux ouvertures de fente extérieures forment un angle de 90° et **en ce que** des éléments sensibles au champ magnétique (2) qui présentent la même direction de sensibilité (4) sont placés dans les segments de fente.

11. Dispositif selon la revendication 10, **caractérisé en ce que**, dans chaque cas, la direction de sensibilité des éléments sensibles au champ magnétique et la ligne de jonction des deux ouvertures de fente correspondantes forment un angle d'environ 45°.

12. Dispositif selon l'une des revendications 1 à 11, **caractérisé en ce qu'**à côté de la région de surface faite de matériau magnétique doux, au moins au nombre de une, sont disposés des éléments de mesure sensibles au champ magnétique additionnels au moyen desquels sont détectées des composantes d'un champ magnétique extérieur qui agissent perpendiculairement au plan de la puce de capteur (1).
